# FASCICULE DE BREVET EUROPEEN

(11) **EP 2 367 216 B1**
(45) Date de publication et mention de la délivrance du brevet: **05.10.2016**
(21) Numéro de dépôt: 11290116.0
(22) Date de dépôt: 08.03.2011
(51) Int. Cl.: H01L 51/50

(54) **Diode électroluminescente hybride à rendement élevé**
Hybride elektroluminescente Diode mit hohem Wirkungsgrad
Hybrid electroluminescent diode with high efficiency

(30) Priorité: 16.03.2010 FR 1001045
(43) Date de publication de la demande: 21.09.2011
(73) Titulaire: Commissariat à l'Énergie Atomique et aux Énergies Alternatives, 75015 Paris (FR)
(72) Inventeur: Vaufrey, David, 38000 Grenoble (FR)
(74) Mandataire: Gevers & Orès

(56) Documents cités:
- WO-A1-2009/041688
- JP-A- 2008 300 270
- ANIKEEVA P O ET AL: "Photoluminescence of CdSe/ZnS core/shell quantum dots enhanced by energy transfer from a phosphorescent donor", CHEMICAL PHYSICS LETTERS, NORTH-HOLLAND, AMSTERDAM, NL LNKD- DOI:10.1016/J.CPLETT.2006.04.009, vol. 424, 21 avril 2006 (2006-04-21), pages 120-125, XP002598796, ISSN: 0009-2614
- LIU H W ET AL: "Enhanced phosphorescence and electroluminescence in triplet emitters by doping gold into cadmium selenide/zinc sulfide nanoparticles", THIN SOLID FILMS, ELSEVIER-SEQUOIA S.A. LAUSANNE, CH LNKD- DOI:10.1016/J.TSF.2005.04.094, vol. 489, no. 1-2, 1 octobre 2005 (2005-10-01), pages 296-302, XP004997864, ISSN: 0040-6090

## Description

L'invention porte sur une diode électroluminescente hybride organique/boîtes quantique présentant un rendement élevé.

Les diodes électroluminescentes organiques (aussi connues sous l'acronyme anglais « OLED ») sont des composants optoélectroniques en développement rapide, utilisés essentiellement pour la réalisation d'écran plats.

Alors qu'une diode électroluminescente « classique » est constituée de matériaux semi-conducteurs inorganiques, une OLED est constituée de couches de matériaux organiques. Il en résulte une technologie de fabrications beaucoup plus simple et moins couteuse à mettre en oeuvre. En particulier, les matériaux organiques constituant des OLED peuvent être facilement déposés sur des grandes surfaces pour réaliser des écrans plats à un faible coût.

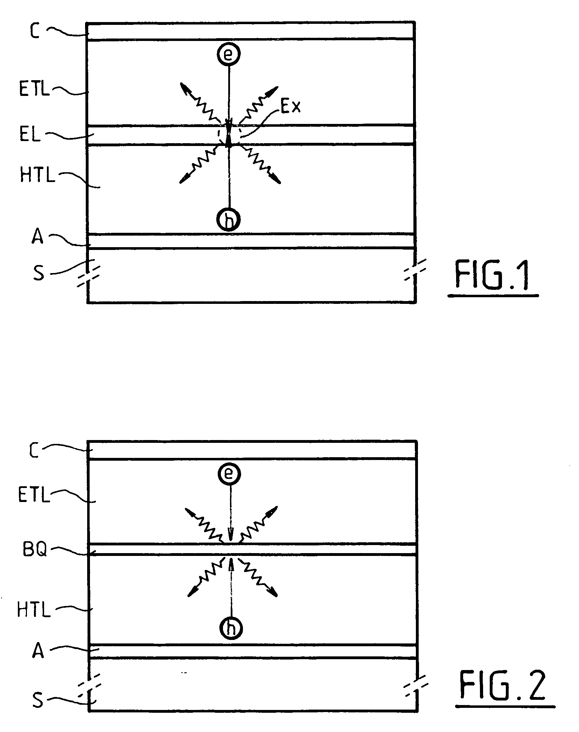

La figure 1 illustre de manière schématique le fonctionnement d'une OLED très simple, formée par un empilement de quatre couches :
- une anode transparente A, par exemple en ITO (Oxyde d'Indium et d'Etain), déposée sur un substrat S en verre ;
- une couche de transport de trous HTL, par exemple en Spiro TTB dopé F4TCNQ ou MoO3 ;
- une couche émettrice EL, par exemple en AIQ3 ou TMM004 dopé Irppy ;
- une couche de transport d'électrons ETL, par exemple en Bphen dopé Ca ou CsCo₃ ; et
- une cathode réfléchissante, par exemple en Ag ou Al.

La couche HTL conduit les trous « h » injectés dans la structure par l'anode ; elle accomplit la fonction de la couche dopée « p » dans les diodes électroluminescentes classiques. Inversement, la couche ETL conduit les électrons « e » injectés dans la structure par la cathode ; elle accomplit donc la fonction de la couche dopée « n » dans les diodes électroluminescentes classiques. Lorsque les électrons et les trous se rencontrent au sein de la couche émettrice, ils forment des excitons EX, c'est à dire des paires liées par interaction coulombienne, qui peuvent se recombiner par voie radiative, émettant un photon. Les photons émis sortent par l'anode et le substrat transparent, éventuellement après réflexion par la cathode métallique (« émission par le bas»). En variante, la cathode peut être transparente, constituée par une couche métallique très fine, et l'anode peut alors être réfléchissante, réalisant ainsi une diode avec « émission par le haut ». Des couches de blocage (non représentées) peuvent être prévues pour limiter la fuite des porteurs au-delà de la couche électroluminescente : en effet, les excitons générés à proximité des électrodes se recombinent le plus souvent de manière non radiative, réduisant le rendement du dispositif. Ce phénomène est connu sous le terme anglais « quenching ».

Un des principaux inconvénients des OLEDS est la grande largeur spectrale du rayonnement qu'elles émettent, ce qui empêche d'obtenir des couleurs suffisamment saturées.

Une solution à ce problème consiste à utiliser des diodes hybrides, comprenant des « boîtes quantiques » associées à des couches semi-conductrices organiques.

Une boîte quantique (« quantum dot » en anglais) est une nanoparticule en matériau semi-conducteur inorganique dont la taille est suffisamment petite pour permettre un confinement des excitons dans les trois dimensions spatiales. Typiquement, une boîte quantique est constituée d'un coeur entouré d'une coquille en matériau semi-conducteur ayant une bande interdite plus large que celle du coeur. Des molécules peuvent être déposées sur cette coquille pour moduler les propriétés chimiques et physico-chimiques de la boîte quantique, par exemple son aptitude à rester en suspension dans un solvant. Les boîtes quantiques sont électroluminescentes, et présentent une bande d'émission relativement étroite par rapport aux émetteurs organiques : intégrées de manière opportune à un composant optoélectronique en tant qu'élément électroluminescent, elles permettent donc d'obtenir des couleurs très saturées.

La figure 2 montre la structure simplifiée d'une diode électroluminescente organique comportant, entre l'HTL et l'ETL, une monocouche BQ de boîtes quantiques. Dans ce dispositif, l'HTL et l'ETL injectent des trous et des électrons, respectivement, dans les boîtes quantiques, où ces porteurs se lient pour former des excitons. Une fraction de ces excitons se recombinent par voie radiative, émettant une lumière dont le spectre dépend exclusivement des propriétés des boîtes quantiques, et pas de celles des couches organiques HTL, ETL.

D'une manière connue en soi, il est nécessaire que les niveaux énergétiques des couches HTL, ETL soient adaptés aux bandes énergétiques des boîtes quantiques pour permettre une injection efficace des porteurs.

Les diodes quantiques hybrides organiques/boîtes quantiques, ainsi que leurs procédés de fabrication, sont décrites en détail par les articles suivants :
- Polina O. Anikeeva, Jonathan E. Halpert, Moungi G. Bawendi, Vladimir Bulovic, « Quantum Dot Light-Emitting Devices with Electroluminescence Tunable over the Entire Visible Spectrum », Nano Letters 2009, Vol. 9, n°7, pages 2532-2536 ; et
- Seth Coe-Sullivan, Jonathan S. Steckel, LeeAnn Kim, Moungi G. Bawendi, Vladimir Bulovic « Method for fabrication of saturated RGB quantum dot light emitting devices » Proc. SPIE 5739 (2005) 108-115.

Le rendement de ces dispositifs est limité par la statistique de spin des porteurs. En effet, il est bien connu que les excitons se présentent sous deux formes : les états singulets, dont le moment angulaire total de spin est nul (S=0) et les états triplets, dont le moment angulaire total de spin vaut un (S=1). Il y a trois niveaux triplets pour un niveau singulet ; autrement dit 75% des excitons se trouvent dans un état triplet et 25% dans un état singulet.

L'état fondamental atteint après recombinaison présente un moment angulaire total de spin égal à zéro ; par conséquent, des considérations de symétrie empêchent que la recombinaison des états triplets puisse se faire par une transition de dipôle électrique. Il s'ensuit que ces états présentent une durée de vie très supérieure à celle des singulets, et se recombinent le plus souvent par voie non radiative. A cause de cela, dans les matériaux fluorescents seuls les excitons singulets contribuent à l'éctroluminescence, dont le rendement ne peut donc excéder 25%.

Il en va autrement dans les matériaux phosphorescents, où un couplage spin-orbite fort induit le mixage des états triplets et singulets et permet aux états triplets de se désexciter radiativement par conversion intersystème. Cet effet est parfois exploité dans des OLED comportant une couche émettrice phosphorescente. Une autre technique consiste à mélanger des molécules fluorescentes et un « sensibilisateur » phosphorescent dans une matrice organique non électroluminescente. Dans certaines conditions, les triplets du sensibilisateur phosphorescent peuvent céder leur énergie par transfert non radiatif de type Förster aux molécules fluorescentes, responsables de l'émission du dispositif. Cette technique est décrite dans l'article de M. A. Baldo, M. E. Thompson et S. R. Forrest « High-efficiency fluorescent organic light-emitting devices using a phosphorescent sensitizer » Nature 403(2000), pages 750 - 753, et par exemple dans les demandes de brevet JP 2008/300270 A et WO 20091041 88 A1. Malheureusement la plupart des boîtes quantiques ne présentent pas de voie efficace de conversion intersystème, ce qui limite le rendement des diodes hybrides organiques / boîtes quantiques. L'adaptation de la technique proposée par l'article précitée de M.A. Baldo et al. à ces dispositifs n'est pas aisée.

L'article de Polina O. Anikeeva et al. « Photoluminescence of CdSe/ZnS core/shell quantum dots enhanced by energy transfer from a phosphorescent donor », Chemical Physics Letters 424 (2006) 120-125 fait état d'un transfert excitonique d'un matériau phosphorescent vers des boîtes quantiques. Cette technique ne présente un intérêt que pour des boîtes quantiques permettant une conversion intersystème efficace, ce qui n'est pas vrai en général. En outre, le dispositif décrit par cet article est photoluminescent, et non électroluminescent, et met en oeuvre une couche phosphorescente épaisse. L'utilisation d'une couche aussi épaisse pour la réalisation d'une diode électroluminescente conduirait à des composants fortement consommateurs d'énergie.

Un autre phénomène vient limiter le rendement des diodes électroluminescentes hybrides organiques / boîtes quantiques. En effet l'efficacité de ces dispositifs dépend de la capacité des porteurs à se placer sur les niveaux des boîtes quantiques. Or il y a un fort désalignement entre les bandes de valence et de conduction des boîtes quantiques et les niveaux HOMO {« highest occupied molecular orbital », c'est à dire orbital moléculaire occupé le plus élevé) et LUMO (« lowest unoccupied molecular orbital », c'est à dire orbital moléculaire non occupé le plus bas) des semi-conducteurs organiques adjacents. A cause de ce désalignement, seule une petite fraction des paires qui se forment se recombine dans les boîtes quantiques. Ce phénomène est accentué par la très faible épaisseur de la couche BQ, qui permet aux porteurs de s'échapper. L'art antérieur ne fournit aucune solution à ce problème.

L'invention vise à améliorer le rendement des diodes hybrides organiques / boîtes quantiques.

Conformément à l'invention ce but peut être atteint par une diode électroluminescente hybride comprenant une anode, une couche organique de transport de trous injectés dans la diode à partir de ladite anode, une couche de boîtes quantiques électroluminescentes, une couche de transport d'électrons et une cathode pour injecter des électrons dans ladite couche de transport, caractérisée en ce qu'elle comprend également, entre lesdites couches de transport de trous et d'électrons, au moins un ensemble formé par une couche électroluminescente phosphorescente présentant un spectre d'émission qui recouvre au moins en partie un spectre d'absorption desdites boîtes quantiques et par une couche tampon séparant ladite couche phosphorescente de ladite couche de boîtes quantiques, le matériau de ladite ou de chaque couche tampon présentant une bande interdite supérieure à celle d'un élément phosphorescent de ladite couche phosphorescente de manière à empêcher la diffusion d'excitons vers ladite couche de boîtes quantiques.
- De façon conventionnelle, la couche électroluminescente est généralement constituée d'une matrice transparente dans laquelle un élément phosphorescent est introduit sous la forme de dopant. Dans certains cas, cependant, une couche électroluminescente homogène peut être utilisée : dans ce cas, l'élément phosphorescent forme l'intégralité de la couche.

Dans une diode électroluminescente selon l'invention, seulement une partie des électrons et des trous sont injectés dans les boîtes quantiques pour y former des excitons (à 25% des singulets et à 75% des triplets).

D'autres paires de porteurs forment des excitons à l'intérieur de la couche électroluminescente phosphorescente ; ces excitons - qu'ils soient dans des états singulets ou triplets - se recombinent de manière radiative avec une très haute efficacité, émettant des photons qui peuvent être absorbés par les boîtes quantiques. Il en résulte un pompage optique de ces dernières. Les excitons crées par pompage optique dans les boîtes quantiques sont nécessairement de type singulet, et peuvent donc se recombiner radiativement.

Cependant, ce schéma ne pourrait pas fonctionner si la couche phosphorescente était directement en contact avec les boîtes quantiques. En effet, lorsqu'un accepteur fluorescent est directement en contact avec un donneur phosphorescent, il se produit un transfert non radiatif d'énergie de type Dexter depuis les excitons triplets du donneur vers des excitons - également de type triplet - de l'accepteur. En d'autres termes l'émission phosphorescente est supprimée et de l'énergie est perdue sous la forme d'excitons triplets dans l'accepteur fluorescent, qui se recombineront de manière non radiative. Par conséquent, un élément essentiel de l'invention est une couche tampon qui sépare la couche phosphorescente de la couche de boîtes quantiques, tout en permettant le passage des photons de pompage.

Les boîtes quantiques ont un spectre d'absorption très large, qui couvre pratiquement toutes les longueurs d'onde inférieures à celle d'émission. On a donc une grande latitude de choix pour l'émetteur phosphorescent : il suffit qu'il émette des photons d'énergie supérieure à celle d'émission des boîtes quantiques.

Selon des modes de réalisation particuliers de l'invention :
- Ladite ou chaque couche tampon peut présenter une épaisseur supérieure à 3 nm, afin d'empêcher efficacement les transferts d'énergie de type Dexter. En même temps, elle ne devrait pas être trop épaisse pour ne pas affecter défavorablement la conductivité de la diode. Son épaisseur peut être comprise, par exemple, entre 10 et 30 nm.
- Au moins une, parmi ladite anode et ladite cathode, peut être adaptée pour réfléchir la lumière émise par ladite ou chaque couche phosphorescente (afin d'améliorer l'efficacité du pompage optique) ; et au moins une, parmi ladite anode et ladite cathode, peut être sensiblement transparente à la lumière émise par lesdites boîtes quantiques (afin de permettre l'extraction de cette lumière).
- Plus particulièrement, la diode peut comprendre une seule couche phosphorescente, qui peut être agencée avantageusement entre ladite couche de boîtes quantiques et celle, parmi ladite anode et ladite cathode, qui est la plus réfléchissante pour la lumière émise par ladite couche phosphorescente. Cet agencement favorise l'efficacité du pompage optique.
- En variante, la diode peut comporter deux dits ensembles constitués par une couche électroluminescente phosphorescente et une couche tampon respective, disposés de part et d'autre de ladite couche de boîtes quantiques électroluminescentes.
- Lesdites couches phosphorescente(s), tampon et de boîtes quantiques peuvent être positionnées à l'intérieur d'une cavité optique adaptée pour confiner la lumière émise par ladite ou chaque couche phosphorescente mais pas la lumière émise par lesdites boîtes quantiques électroluminescentes. Cet agencement maximise l'efficacité du pompage optique des boîtes quantiques.
- D'une manière particulièrement avantageuse : l'une, parmi ladite anode et ladite cathode, peut être adaptée pour réfléchir efficacement la lumière émise tant par ladite ou chaque couche phosphorescente que par lesdites boîtes quantiques ; et l'autre, parmi ladite anode et ladite cathode, peut être sensiblement transparente à la lumière émise tant par ladite ou chaque couche phosphorescente que par lesdites boîtes quantiques ; un miroir diélectrique multicouches (« réseau de Bragg ») adapté pour réfléchir sélectivement la lumière émise par ladite ou chaque couche phosphorescente étant alors prévu pour compléter ladite cavité optique.
- Lorsqu'une cavité optique est réalisée, il est avantageux que ladite couche de boîtes quantiques soit positionnée au niveau d'un ventre de l'onde stationnaire formée par la lumière émise par ladite couche phosphorescente et piégée par ladite cavité optique. Etant donné que la couche phosphorescente est généralement positionnée au niveau d'un plan nodal de la cavité, l'épaisseur de la couche tampon doit de préférence rendre possible un bon positionnement de la couche de boîtes quantiques.
- L'ensemble constitué par ladite ou chaque couche électroluminescente phosphorescente, ladite ou chaque couche tampon et la couche de boîtes quantiques peut être enfermé entre une couche d'arrêt des électrons, côté anode, et une couche d'arrêt des trous, côté cathode. Cela permet de concentrer les porteurs (électrons et trous) à proximité tant des boîtes quantiques que de la couche phosphorescente, améliorant l'efficacité du pompage électrique et optique. Cela limite aussi l'émission parasite de lumière par d'autres couches de la diode.
- Lesdites boîtes quantiques peuvent être d'au moins un type choisi parmi : CdS/ZnS ; CdSe/ZnS ; ZnSe/CdSe/ZnS ; CdSe/ZnS ; dS/ZnS ; CdₓHg₁₋ₓTe ; PbS ; InAs/ZnSe ; PbSe.
- Ladite ou chaque couche tampon peut être constituée d'un matériau choisi parmi : TMM060 (nom commercial) ; TAZ (3-(4-Biphenylyl)-4-phenyl-5-tert-butylphenyl-1,2,4-triazole) ; BCP (Bathocuproine) ; Bphen (Bathophenantroline) ; TCTA ((4,4',4"-Tris(carbazol-9-yl)triphenylamine)) ; NPB (N,N'-Bis(naphthalen-1-yl)-N,N'-bis(phenyl)benzidine) ; CBP (4,4'-Bis(carbazol-9-yl)biphenyl) ; et un mélange de deux ou plus de ces matériaux. TMM060, TAZ, BCP et Bphen sont des conducteurs d'électrons tandis que TCTA, NPB et CBP sont des conducteurs de trous. Pour maximiser le rendement, il est préférable que la couche tampon soit constituée d'un mélange d'au moins un premier matériau conducteur d'électrons et un deuxième matériau conducteur de trous.
- Ladite couche de boîtes quantiques électroluminescentes peut être adaptée pour émettre un rayonnement infrarouge, en particulier avec une longueur d'onde pouvant atteindre - voire dépasser - les 5 µm.

D'autres caractéristiques, détails et avantages de l'invention ressortiront à la lecture de la description faite en référence aux dessins annexés donnés à titre d'exemple et qui représentent, respectivement :
- La figure 1, décrite plus haut, la structure d'une diode électroluminescente organique conventionnelle ;
- La figure 2, décrite plus haut, la structure d'une diode électroluminescente hybride organique/boîtes quantiques connue de l'art antérieur ;
- La figure 3, la structure d'une diode électroluminescente hybride organique/boîtes quantiques selon un premier mode de réalisation de l'invention, émettant par le bas de la lumière visible ;
- La figure 4, la structure d'une diode électroluminescente hybride organique/boîtes quantiques selon un deuxième mode de réalisation de l'invention, émettant par le haut de la lumière visible ;
- La figure 5, la structure d'une diode électroluminescente hybride organique/boîtes quantiques selon un troisième mode de réalisation de l'invention, émettant par le bas de la lumière infrarouge ;
- La figure 6, la structure d'une diode électroluminescente hybride organique/boîtes quantiques selon un quatrième mode de réalisation de l'invention, émettant par le haut de la lumière infrarouge ; et

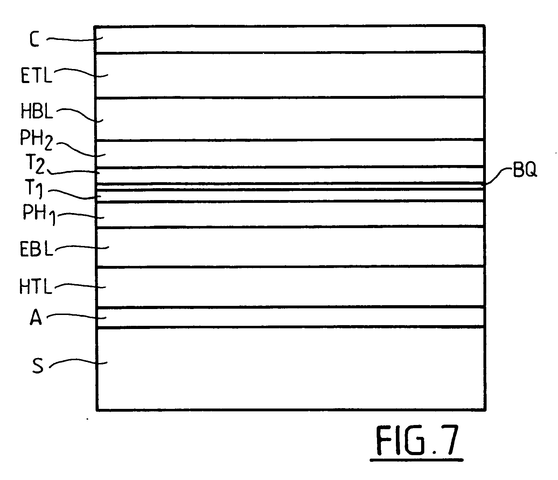

- La figure 7, la structure d'une diode électroluminescente hybride organique/boîtes quantiques selon un quatrième mode de réalisation de l'invention, comportant deux couches phosphorescentes et deux couches tampon respectives, disposées de part et d'autre de la couche de boîtes quantiques.

Sur ces figures, les épaisseurs des différentes couches ne sont pas à l'échelle.

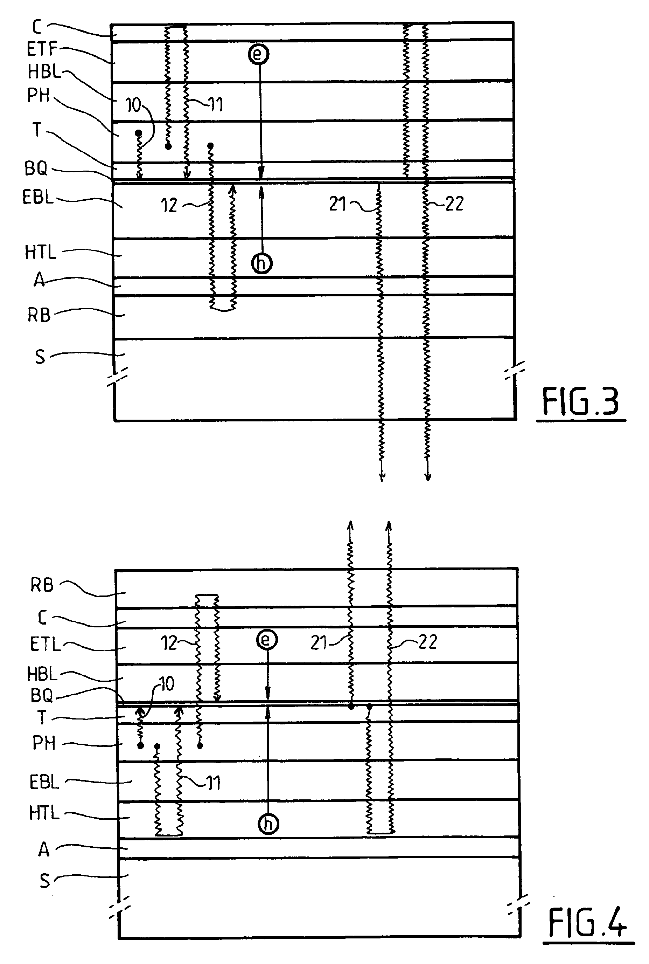

La diode électroluminescente représentée en coupe sur la figure 3 se présente sous la forme d'un empilement de couches sur un substrat S, en verre ou en un autre matériau transparent. Du bas vers le haut on peut identifier :
- Un réseau de Bragg RB formé par une alternance de couches diélectriques d'indices de réfraction différents. Ce réseau de Bragg est dimensionné pour réfléchir la lumière émise par la couche phosphorescente et pour laisser passer la lumière émise par les boîtes quantiques.
- Une anode A réalisée en ITO ou bien par une couche métallique suffisamment mince pour être sensiblement transparente à la lumière émise par les boîtes quantiques (par exemple : 30 nm ou moins de Ag).
- Une couche de transport des trous HTL en Spiro TTB (2,2',7,7'-tetra(N, N-di-tolyl)amino-spiro-bifluorene) dopé F4TCNQ (7,7,8,8-Tetracyano-2,3,5,6-tetrafluoroquinodimethane, ou (2,3,5,6-Tetrafluoro-2,5-cyclohexadiene-1,4-diylidene)dimalononitrile) ou MoO₃ (typiquement de 20 à 200nm d'épaisseur).

- Une couche d'arrêt des électrons EBL en Spiro TAD (2,2',7,7'-Tetrakis(n,n-diphenylamino)- 9,9'-spirobifluorene) ou NPB (typiquement de 3 à 20nm d'épaisseur).
- Une monocouche BQ de boîtes quantiques émettant dans le visible.
- Une couche tampon T (typiquement de 3 à 30 nm d'épaisseur) en TMM060 dopé TCTA typiquement à 25% en masse. En raison de sa faible épaisseur, cette couche tampon est sensiblement transparente au rayonnement émis par la couche phosphorescente. Elle peut aussi être choisie de manière à minimiser l'absorption de ce rayonnement.
- Une couche électroluminescente phosphorescente en TMM004 dopé Irppy (Tris(2-phenylpyridine)iridium(III)), émettant par exemple dans le vert et en tout cas à une longueur d'onde comprise dans le spectre d'absorption des boîtes quantiques (typiquement de 3 à 20nm d'épaisseur). En raison de la largeur de la bande spectrale d'absorption des boîtes quantiques, le choix de l'émetteur phosphorescent n'est pas critique. De nombreux composés organométalliques avec un centre métallique lourd (en particulier un lanthanide) peuvent convenir pour la mise en oeuvre de l'invention.
- Une couche d'arrêt des trous HBL en Bphen ou BCP ou Alq3 (Tris-(8-hydroxyquinoline)aluminum) ou TPBi (2,2',2"-(1,3,5-Benzinetriyl)-tris(1-phenyl-1-H-benzimidazole)) ou BAlq3 (Bis-(2-methyl-8-quinolinolate)-4-(phenylphenolato)aluminium) (typiquement de 20 à 200nm d'épaisseur).
- Une couche de transport des électrons ETL en Bphen dopé Ca ou en Bphen dopé CsCO₃.
- Une cathode C réfléchissante, par exemple en Ag, Al, Ca/Ag, Ca/Al ou Ba/Al.

En général, si les couches sous-jacentes ont été déposées par voie humide, la couche BQ de boîtes quantiques sera elle-aussi déposée par voie humide, en particulier à la tournette (spin coating en anglais) ou par impression par jet d'encre. Dans le cas contraire (notamment si les couches sous-jacentes sont constituées de petites molécules déposées par évaporation thermique), on préférera déposer la couche BQ par microtamponnage afin d'éviter la solvatation des couches sous-jacentes.

Les boîtes quantiques de la couche BQ sont pompées optiquement par les photons émis par la couche phosphorescente PH. A titre d'exemple la référence 10 indique un photon de pompage qui est absorbé directement par une boîte quantique ; la référence 11, un photon qui est absorbé après avoir été émis dans une direction opposée à celle des boîtes quantiques et avoir été réfléchi par la cathode métallique ; et la référence 12 un photon qui est absorbé après avoir traversé une première fois la couche BQ et avoir été réfléchi par la cathode C.

Les boîtes quantiques sont aussi pompées électriquement par injection d'électrons « e » et trous « h » provenant des électrodes.

La référence 21 indique un photon émis par une boîte quantique en direction de l'anode et du substrat. Comme ces éléments sont transparents, le photon peut les traverser (émission par le bas). La référence 22 indique un photon émis dans la direction opposée, qui est réfléchi par la cathode avant de quitter à son tour le dispositif à travers le substrat.

La figure 4 montre une diode électroluminescente émettant de la lumière visible, mais « par le haut », c'est-à-dire par sa surface opposée au substrat.

Dans ce cas l'anode est réfléchissante, réalisée par exemple en Al[TiN, Al/W, Al/Mo, W ou Mo, et elle est déposée directement sur le substrat. C'est la cathode qui doit être transparente : elle peut être constituée d'une couche mince (épaisseur typiquement inférieure à 30 nm) en Ag, Al, Ca/Ag, Ca/Al ou Ba/AI. Le substrat peut être en verre ou en tout autre matériau adapté, car il n'a plus à être transparent.

Le réseau de Bragg RB est déposé au-dessus de la cathode. Au-dessous de ce réseau, on peut prévoir une couche dite de « capping », en SiO, MoO₃, ZnSe, TeO₂ ou Sb₂O₃ par exemple, permettant d'accroitre le flux extrait de la diode. En variante, le réseau de Bragg peut être conçu de manière à accomplir également ce rôle.

On remarquera que l'ordre des couches a changé, car dans ce dispositif la couche phosphorescente PH est disposée du côté de l'anode, qui constitue le miroir le plus réfléchissant de la cavité optique formée par l'anode elle-même et le réseau de Bragg. Cette disposition (qui n'est pas essentielle, mais fortement conseillée) optimise l'efficacité du pompage optique des boîtes quantiques.

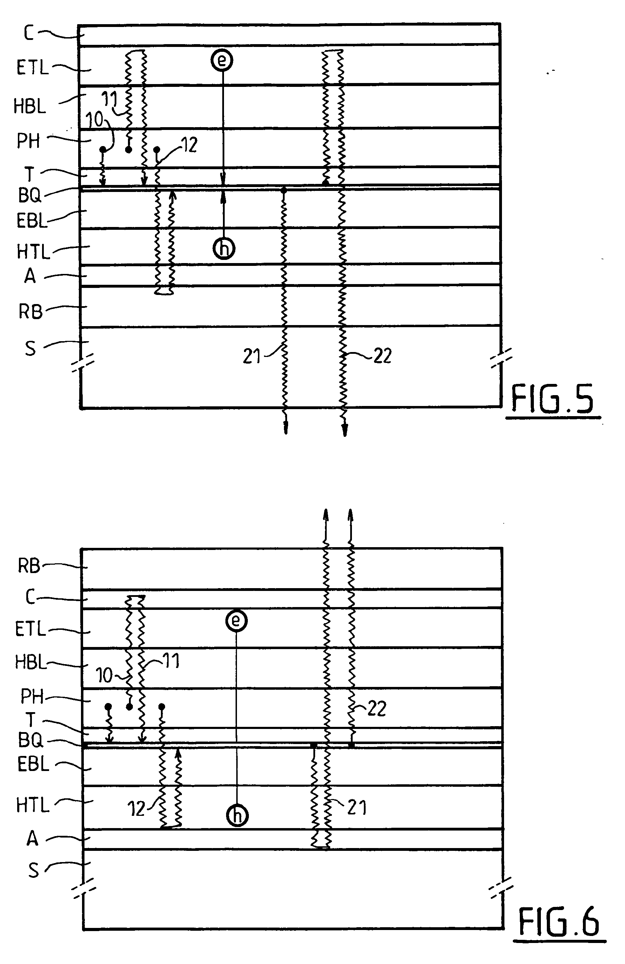

La diode électroluminescente de la figure 5 est adaptée pour émettre un rayonnement infrarouge « par le bas », c'est-à-dire à travers son substrat S. Ce dernier peut être en Silicium, matériau qui est transparent dans cette région spectrale pour des longueurs d'onde jusqu'à 8 µm environ.

L'agencement des couches est le même que dans le cas de la figure 3 :
- Comme dans le cas précédent le réseau de Bragg RB est dimensionné pour réfléchir la lumière émise par la couche phosphorescente et pour laisser passer la lumière émise par les boîtes quantiques.
- L'anode A est constituée d'une couche métallique mince, par exemple : 20 nm ou moins de Ag, W ou Mo. En variante, il pourra s'agir également d'un maillage métallique afin d'extraire plus de photons.
- La couche de transport des trous HTL en Spiro TTB dopé F4TCNQ ou MoO3 présente une épaisseur comprise entre 10 et 100 nm.
- La couche d'arrêt des électrons EBL en Spiro TAD ou NPB présente une épaisseur comprise entre 3 et 20 nm.
- La monocouche BQ est constituée de boîtes quantiques émettant dans l'infrarouge et absorbant la lumière visible émise par la couche phosphorescente.
- La couche tampon T en TMM060 dopé TCTA présente une épaisseur comprise entre 3 et 30 nm.
- La couche électroluminescente phosphorescente en TMM004 dopé Irppy présente une épaisseur de 10 à 20 nm et émet, par exemple, dans le vert.
- La couche d'arrêt des trous HBL en Bphen ou BCP ou Alq3 ou TPBi ou BAq3 présente une épaisseur comprise entre 3 et 20 nm.
- La couche de transport des électrons ETL en Bphen dopé Ca ou en Bphen dopé CsCO₃ présente une épaisseur comprise entre 10 et 100 nm.
- La cathode C réfléchissante peut être en Ag ou Al et présenter une épaisseur supérieure à 100 nm pour être suffisamment réfléchissante.

En variante, la couche phosphorescente et la couche tampon peuvent être disposées du côté de l'anode. En tout cas la couche tampon doit séparer la couche phosphorescente des boîtes quantiques.

La diode de la figure 6 émet par le haut. Elle ne se différencie de celle de la figure 5 que par l'ordre des couches.

Il est également possible d'envisager l'utilisation de deux couches phosphorescentes PH₁, PH₂ (éventuellement constituées de matériaux différents), disposés de part et d'autre de la couche de boîtes quantiques et séparées de celle-ci par des couches tampon respectives T₁, T₂.

Il faut comprendre que les exemples donnés ici ne sont pas limitatifs. D'autres matériaux que ceux listés ici peuvent être utilisés, et les épaisseurs des couches sont données à titre purement indicatif. Par ailleurs, les couches d'arrêt des électrons et des trous peuvent être absentes, ou les couches de transport peuvent accomplir également leur fonction. Le réseau de Bragg n'est qu'un mode de réalisation particulièrement avantageux d'un miroir sélectif en longueur d'onde. Par ailleurs, l'utilisation d'une cavité optique n'est pas essentielle, bien qu'elle soit particulièrement avantageuse.

## Revendications

1. Diode électroluminescente hybride organique/boîtes quantiques comprenant une anode (A), une couche organique (HTL) de transport de trous (h) injectés dans la diode à partir de ladite anode, une couche (BQ) de boîtes quantiques électroluminescentes, une couche (ETL) de transport d'électrons et une cathode (C) pour injecter des électrons (e) dans ladite couche de transport, **caractérisée en ce qu'**elle comprend également, entre lesdites couches de transport de trous et d'électrons, au moins un ensemble formé par une couche électroluminescente phosphorescente (PH) présentant un spectre d'émission qui recouvre au moins en partie un spectre d'absorption desdites boîtes quantiques et par une couche tampon (T) séparant ladite couche phosphorescente de ladite couche de boîtes quantiques, le matériau de ladite ou de chaque couche tampon présentant une bande interdite supérieure à celle d'un élément phosphorescent de ladite couche phosphorescente de manière à empêcher la diffusion d'excitons vers ladite couche de boîtes quantiques.

2. Diode électroluminescente hybride selon la revendication précédente dans laquelle ladite ou chaque couche tampon présente une épaisseur supérieure à 3 nm.

3. Diode électroluminescente hybride selon la revendication 2 dans laquelle ladite ou chaque couche tampon présente une épaisseur comprise entre 10 et 30 nm.

4. Diode électroluminescente hybride selon l'une des revendications précédentes dans laquelle au moins une, parmi ladite anode et ladite cathode, est adaptée pour réfléchir la lumière émise par ladite ou par chaque couche phosphorescente ; et au moins une, parmi ladite anode et ladite cathode, est sensiblement transparente à la lumière émise par lesdites boîtes quantiques.

5. Diode électroluminescente hybride selon la revendication 4 comprenant une seule couche phosphorescente qui est agencée entre ladite couche de boîtes quantiques et celle, parmi ladite anode et ladite cathode, qui est la plus réfléchissante pour la lumière émise par ladite couche phosphorescente.

6. Diode électroluminescente hybride selon l'une des revendications 1 à 4 comportant deux dits ensembles constitués par une couche électroluminescente phosphorescente (PH₁, PH₂) et une couche tampon respective (T₁, T₂), disposés de part et d'autre de ladite couche (BQ) de boîtes quantiques électroluminescentes.

7. Diode électroluminescente hybride selon l'une des revendications précédentes dans laquelle lesdites couches phosphorescente(s), tampon et de boîtes quantiques sont positionnées à l'intérieur d'une cavité optique adaptée pour piéger la lumière émise par ladite ou chaque couche phosphorescente mais pas la lumière émise par lesdites boîtes quantiques électroluminescentes

8. Diode électroluminescente hybride selon la revendication 7 dans laquelle :
- l'une, parmi ladite anode et ladite cathode, est adaptée pour réfléchir efficacement la lumière émise tant par ladite ou chaque couche phosphorescente que par lesdites boîtes quantiques ; et
- l'autre, parmi ladite anode et ladite cathode, est sensiblement transparente à la lumière émise tant par ladite ou chaque couche phosphorescente que par lesdites boîtes quantiques ; un miroir diélectrique multicouches (RB) adapté pour réfléchir sélectivement la lumière émise par ladite ou chaque couche phosphorescente étant prévu pour compléter ladite cavité optique.

9. Diode électroluminescente hybride selon l'une des revendications 7 ou 8 dans laquelle ladite couche de boîtes quantiques est positionnée au niveau d'un ventre de l'onde stationnaire formée par la lumière émise par ladite ou chaque couche phosphorescente et piégée par ladite cavité optique.

10. Diode électroluminescente hybride selon l'une des revendications précédentes dans laquelle l'ensemble constitué par ladite ou chaque couche électroluminescente phosphorescente, ladite ou chaque couche tampon et la couche de boîtes quantiques est enfermé entre une couche de blocage des électrons, côté anode, et une couche de blocage des trous, côté cathode.

11. Diode électroluminescente hybride selon l'une des revendications précédentes dans laquelle lesdites boîtes quantiques sont d'au moins un type choisi parmi : CdS/ZnS ; CdSe/ZnS ; ZnSe/CdSe/ZnS ; CdSe/ZnS ; CdS/ZnS ; CdₓHg₁₋ₓTe ; PbS ; InAs/ZnSe ; PbSe.

12. Diode électroluminescente hybride selon l'une des revendications précédentes dans laquelle ladite ou chaque couche tampon est constituée d'un matériau choisi parmi : TMM060 ; TAZ ; BCP ; Bphen ; TCTA ; NPB ; CBP ; et un mélange de deux ou plus de ces matériaux.

13. Diode électroluminescente hybride selon l'une des revendications précédentes dans laquelle ladite ou chaque couche tampon est constituée d'un mélange d'au moins un premier matériau conducteur d'électrons et un deuxième matériau conducteur de trous.

14. Diode électroluminescente hybride selon l'une des revendications précédentes dans lequel ladite couche (BQ) de boîtes quantiques électroluminescentes est adaptée pour émettre un rayonnement infrarouge.

## Patentansprüche

1. Hybride organische/Quantenpunkt elektrolumineszente Diode, die eine Anode (A), eine organische Schicht (HTL) zum Transport von ausgehend von der Anode in die Diode injizierten Löchern (h), eine Schicht (BQ) aus elektrolumineszenten Quantenpunkten, eine Elektronentransportschicht (ETL) und eine Kathode (C) zum Injizieren der Elektronen (e) in die Transportschicht umfasst, **dadurch gekennzeichnet, dass** sie zwischen der Loch- und der Elektronentransportschicht auch mindestens eine Baugruppe umfasst, die durch eine phosphoreszierende elektrolumineszente Schicht (PH), die ein Emissionsspektrum aufweist, das ein Absorptionsspektrum der Quantenpunkte mindestens teilweise abdeckt, und durch eine Pufferschicht (T) gebildet ist, die die phosphoreszierende Schicht von der Schicht aus Quantenpunkten trennt, wobei das Material von der oder jeder Pufferschicht ein verbotenes Band aufweist, das höher ist als dasjenige eines phosphoreszierenden Elements der phosphoreszierenden Schicht, derart, dass die Exzitonendiffusion in Richtung der Quantenpunktschicht verhindert wird.

2. Hybride elektrolumineszente Diode nach dem vorhergehenden Anspruch, wobei die oder jede Pufferschicht eine Dicke aufweist, die höher als 3 nm ist.

3. Hybride elektrolumineszente Diode nach Anspruch 2, wobei die oder jede Pufferschicht eine Dicke aufweist, die zwischen 10 und 30 nm enthalten ist.

4. Hybride elektrolumineszente Diode nach einem der vorhergehenden Ansprüche, wobei mindestens eine von der Anode und der Kathode angepasst ist, um das durch die oder durch jede phosphoreszierende Schicht emittierte Licht zu reflektieren; und mindestens eine von der Anode und der Kathode gegenüber dem durch die Quantenpunkte emittierten Licht im Wesentlichen durchlässig ist.

5. Hybride elektrolumineszente Diode nach Anspruch 4, die eine einzige phosphoreszierende Schicht aufweist, die zwischen der Schicht aus Quantenpunkten und derjenigen von der Anode und der Kathode angeordnet ist, die für das durch die phosphoreszierende Schicht emittierte Licht die reflektierendste ist.

6. Hybride elektrolumineszente Diode nach einem der Ansprüche 1 bis 4, die zwei der Baugruppen umfasst, die aus einer phosphoreszierenden elektrolumineszenten Schicht (PH₁, PH₂) und einer entsprechenden Pufferschicht (T₁, T₂) bestehen, die auf beiden Seiten der Schicht (BQ) aus elektrolumineszenten Quantenpunkten angeordnet sind.

7. Hybride elektrolumineszente Diode nach einem der vorhergehenden Ansprüche, wobei die phosphoreszierende/n Puffer- und Quantenpunkt-Schichten im Inneren eines optischen Resonators positioniert sind, der angepasst ist, um das durch die oder jede phosphoreszierende Schicht emittierte Licht aber nicht das durch die elektrolumineszenten Quantenpunkte emittierte Licht einzufangen.

8. Hybride elektrolumineszente Diode nach Anspruch 7, wobei:
- eine von der Anode und der Kathode angepasst ist, um sowohl das durch die oder jede phosphoreszierende Schicht als auch durch die Quantenpunkte emittierte Licht wirksam zu reflektieren; und
- die andere von der Anode und der Kathode im Wesentlichen gegenüber dem durch sowohl die oder jede phosphoreszierende Schicht als auch dem durch die Quantenpunkte emittierten Licht durchlässig ist; wobei ein mehrschichtiger dielektrischer Spiegel (RB), der angepasst ist, um das durch die oder jede phosphoreszierende Schicht emittierte Licht selektiv zu reflektieren, vorgesehen ist, um den optischen Resonator zu ergänzen.

9. Hybride elektrolumineszente Diode nach einem der Ansprüche 7 oder 8, wobei die Schicht aus Quantenpunkten im Bereich eines Bauchs der stehenden Welle positioniert ist, die durch das durch die oder jede phosphoreszierende Schicht emittierte Licht gebildet wird und durch den optischen Resonator eingefangen wird.

10. Hybride elektrolumineszente Diode nach einem der vorhergehenden Ansprüche, wobei die Baugruppe, die aus der oder jeder phosphoreszierenden elektrolumineszenten Schicht, der oder jeder Pufferschicht und der Schicht aus Quantenpunkten besteht, zwischen einer Sperrschicht für die Elektronen auf der Anodenseite und einer Sperrschicht für die Löcher auf der Kathodenseite eingeschlossen ist.

11. Hybride elektrolumineszente Diode nach einem der vorhergehenden Ansprüche, wobei die Quantenpunkte von mindestens einem Typ sind, der unter Folgendem ausgewählt ist: CdS/ZnS; CdSe/ZnS; ZnSe/CdSe/ZnS; CdSe/ZnS; CdS/ZnS; CdₓHg₁₋ₓTe; PbS; InAs/ZnSe; PbSe.

12. Hybride elektrolumineszente Diode nach einem der vorhergehenden Ansprüche, wobei die oder jede Pufferschicht aus einem Material besteht, das unter Folgendem ausgewählt ist: TMM060; TAZ; BCP; Bphen; TCTA; NPB; CBP; und eine Mischung aus zwei oder mehr dieser Materialien.

13. Hybride elektrolumineszente Diode nach einem der vorhergehenden Ansprüche, wobei die oder jede Pufferschicht aus einer Mischung aus mindestens einem ersten, für Elektronen leitfähigen Material und einem zweiten, für Löcher leitfähigen Material besteht.

14. Hybride elektrolumineszente Diode nach einem der vorhergehenden Ansprüche, wobei die Schicht (BQ) aus elektrolumineszenten Quantenpunkten angepasst ist, um eine Infrarotstrahlung zu emittieren.

## Claims

1. A hybrid organic/quantum dot LED comprising an anode (A), an organic hole-transport layer (HTL) for transporting holes (h) injected into the diode from said anode, a light-emitting quantum dot layer (BQ), an electron-transport layer (ETL), and a cathode (C) for injecting electrons (e) into said transport layer, **characterized in that** it also comprises, between said hole- and electron-transport layers, at least one assembly formed by a phosphorescent light-emitting layer (PH) presenting an emission spectrum that covers at least part of an absorption spectrum of said quantum dots, and by a buffer layer (T) separating said phosphorescent layer from said quantum dot layer, the material of said or each buffer layer presenting a forbidden band greater than that of a phosphorescent element of said phosphorescent layer so as to prevent excitons diffusing towards said quantum dot layer.

2. A hybrid LED according to the preceding claim, wherein said or each buffer layer presents thickness greater than 3 nm.

3. A hybrid LED according to claim 2, wherein said or each buffer layer presents thickness lying in the range 10 nm to 30 nm.

4. A hybrid LED according to any preceding claim, wherein at least one of said anode and said cathode is adapted to reflect the light emitted by said or each phosphorescent layer; and at last one of said anode and said cathode is substantially transparent to the light emitted by said quantum dots.

5. A hybrid LED according to claim 4, having a single phosphorescent layer that is arranged between said quantum dot layer and that one of said anode and said cathode that is the more reflective for the light emitted by said phosphorescent layer.

6. A hybrid LED according to any one of claims 1 to 4, having two said assemblies constituted by a phosphorescent light-emitting layer (PH_{IR} PH₂) and a respective buffer layer (T₁, T₂) disposed on either side of said light-emitting quantum dot layer (BQ).

7. A hybrid LED according to any preceding claim, wherein said phosphorescent, buffer, and quantum dot layer(s) are positioned inside an optical cavity adapted to trap the light emitted by said or each phosphorescent layer but not the light emitted by said light-emitting quantum dots.

8. A hybrid LED according to claim 7, wherein:
· one of said anode and said cathode is adapted to reflect efficiently the light emitted both by said or each phosphorescent layer and by said quantum dots; and
· the other one of said anode and said cathode is substantially transparent to the light emitted both by said or each phosphorescent layer and by said quantum dots; a multilayer dielectric mirror (RB) adapted to reflect selectively the light emitted by said or each phosphorescent layer being provided to complete said optical cavity.

9. A hybrid LED according to claim 7 or claim 8, wherein said quantum dot layer is positioned at an antinode of the standing wave formed by the light emitted by said or each phosphorescent layer and trapped by said optical cavity.

10. A hybrid LED according to any preceding claim, wherein the assembly constituted by said or each phosphorescent light-emitting layer, said or each buffer layer, and the quantum dot layer is enclosed between an electron blocking layer beside the anode and a hole blocking layer beside the cathode.

11. A hybrid LED according to any preceding claim, wherein said quantum dots are at least of a type selected from: CdS/ZnS; CdSe/ZnS; ZnSe/CdSe/ZnS; CdSe/ZnS; CdS/ZnS; CdₓHg₁₋ₓTe; PbS; InAs/ZnSe; PbSe.

12. A hybrid LED according to any preceding claim, wherein said or each buffer layer is made of a material selected from: TMM060; TAZ; BCP; Bphen; TCTA; NPB; CBP; and a mixture of two or more of these materials.

13. A hybrid LED according to any preceding claim, wherein said or each buffer layer is constituted by a mixture of at least a first material that conducts electrons and a second material that conducts holes.

14. A hybrid LED according to any preceding claim, wherein said light-emitting quantum dot layer (BQ) is adapted to emit infrared radiation.
